# FASCICULE DE BREVET EUROPEEN

(11) **EP 2 994 901 B1**
(45) Date de publication et mention de la délivrance du brevet: **15.03.2017**
(21) Numéro de dépôt: 14726545.8
(22) Date de dépôt: 05.05.2014
(51) Int. Cl.: G02B 3/08, H04N 5/33, G01J 5/00, G01J 5/08, G08B 13/191, G08B 13/193, G08B 29/18, H01L 37/02, G01J 5/34

(54) **DETECTEUR COMPACT DE PRESENCE HUMAINE**
KOMPAKTER DETEKTOR MENSCHLICHER PRÄSENZ
COMPACT HUMAN PRESENCE DETECTOR

(30) Priorité: 06.05.2013 FR 1354137
(43) Date de publication de la demande: 16.03.2016
(73) Titulaire: IRLYNX, 38330 Montbonnot-Saint-Martin (FR)
(72) Inventeur: CAMBOU, Pierre, 38330 Montbonnot-Saint-Martin (FR)
(74) Mandataire: de Jong, Jean Jacques
(86) Numéro de dépôt international: PCT/EP2014/059108
(87) Numéro de publication internationale: WO 2014/180783

(56) Documents cités:
- EP-A1- 0 633 554
- FR-A1- 2 925 765
- US-A- 5 808 350
- US-A1- 2012 268 646

## Description

L'invention concerne la détection de présence humaine dans un environnement donné.

Il existe de nombreuses situations dans lesquelles il est nécessaire de détecter la présence d'une personne, le plus souvent pour des raisons de sécurité, mais parfois pour d'autres raisons. Par exemple, on cherche à détecter des intrusions malveillantes dans un local ou une zone protégée, ou encore on veut s'assurer qu'il n'y a personne dans un endroit dangereux avant d'exécuter une manoeuvre : sur le trajet d'une porte coulissante d'ascenseur ou une porte basculante de garage, derrière un véhicule en marche arrière ou devant un véhicule avançant , etc. Mais on peut aussi envisager des applications non liées à la sécurité, comme le comptage de personnes présentes dans une zone ou le flux de personnes sur un trajet, et toutes sortes d'autres applications dans le domaine de l'interaction Homme-Machine, où il est souhaitable de détecter la présence de personnes au voisinage d'une machine.

Différents systèmes plus ou moins sophistiqués existent pour faire de telles détections : de simples cellules photoélectriques éclairées par des diodes laser pour des portes coulissantes ou basculantes, mais ces cellules ne donnent que des informations très limitées, en tout ou rien. Il existe aussi des caméras numériques, des caméras infrarouges thermiques, des Lidars (détecteurs laser fournissant une mesure en trois dimensions), des radars, ou même une combinaison de plusieurs de ces appareils pour renforcer la capacité de détection, d'identification, ou de comptage des personnes. Les systèmes existants sont coûteux.

On a proposé, dans la publication de brevet US 2012/0268646 d'utiliser une matrice de pixels sensibles à la lumière visible dans lesquels certains pixels sont recouverts d'un détecteur infrarouge et d'une diode électroluminescente qui convertit l'énergie infrarouge reçue en lumière visible pour être détectée par le pixel sous-jacent. On a également proposé dans le brevet US 5 808 350 de recouvrir chaque pixel sensible à la lumière visible d'un bolomètre. Les pixels décrits dans ces documents nécessitent des technologies de fabrication sophistiquées parce que les éléments qui doivent fournir un signal de détection de rayonnement infrarouge sont superposés aux pixels qui doivent détecter la lumière visible.

L'invention a pour but de fournir un détecteur de présence humaine multimodal qui optimise le coût de la détection en évitant d'utiliser des systèmes trop complexes et trop coûteux et en permettant cependant de fournir des images riches en informations sur les personnes éventuellement présentes dans le champ d'observation.

Selon l'invention, on propose un détecteur de présence de personne caractérisé en ce qu'il comporte sur une même puce de silicium réalisée en technologie CMOS une première matrice de pixels, rendus sensibles au rayonnement infrarouge lointain par le dépôt d'une couche pyroélectrique, convertissant en charges électriques le rayonnement infrarouge lointain reçu, juxtaposée avec au moins une deuxième matrice de pixels sensibles à la lumière visible, convertissant en charges électriques la lumière visible reçue, et un circuit de lecture des charges engendrées dans chacune de matrices par la lumière visible ou le rayonnement infrarouge lointain, le détecteur comprenant encore, au-dessus de la puce de silicium, un élément optique de focalisation du rayonnement infrarouge lointain sur la première matrice, et un élément optique de focalisation de la lumière visible sur la deuxième matrice.

Par rayonnement infrarouge lointain, on entend un rayonnement à des longueurs d'onde infrarouge auxquelles le silicium n'est pas sensible. Les longueurs d'onde plus particulièrement concernées par l'invention sont de préférence des longueurs d'onde dans la bande de 8 micromètres à 14 micromètres.

La matrice de pixels sensibles à la lumière visible utilise le silicium comme matériau photosensible et ce matériau est sensible à la lumière visible et au proche infrarouge jusqu'à une longueur d'onde d'environ 1100 nanomètres, et on considérera dans la suite que l'appellation lumière visible inclut par extension le proche infrarouge jusqu'à une longueur d'onde d'environ 1100 nanomètres.

La taille des pixels de la deuxième matrice est de préférence au moins cinq fois et de préférence environ dix fois inférieure à la taille en surface des pixels de la première matrice. La deuxième matrice occupe une faible partie, de préférence inférieure à 25%, de la surface de la première matrice. Elle peut être placée contre un bord ou un coin de la première matrice ; exceptionnellement, elle pourrait aussi être située au centre de la première matrice.

La matrice photosensible en lumière visible peut être divisée en deux parties écartées latéralement l'une de l'autre, permettant une détection d'image visible en trois dimensions, un élément optique de focalisation respectif étant disposé au-dessus de chaque partie.

La première matrice comprend une couche superficielle de matériau pyroélectrique organique, notamment un copolymère en P(VDF-TrFe), c'est-à-dire en poly-(fluorure de vinylidène-tétrafluroéthylène), et des électrodes de part et d'autre de cette couche pour recueillir les charges engendrées dans la couche par le rayonnement infrarouge lointain auquel ce matériau est particulièrement sensible.

L'optique de focalisation est de préférence une lentille de Fresnel, aussi bien pour l'optique de focalisation en lumière visible que pour l'optique de focalisation en lumière infrarouge lointain. Elle est de préférence en polyéthylène ou en silicium. Elle peut être aussi en verre chalcogénide, en fluorure de calcium, baryum ou magnésium, ou en germanium.

Le capteur selon l'invention est très simple puisqu'il ne comporte qu'une puce de circuit intégré, encapsulée dans un boîtier qui enferme aussi les éléments optiques nécessaires à la focalisation de la lumière visible ou infrarouge lointain. Il peut donc être fabriqué à un coût très bas. Il possède une très bonne fiabilité de détection en raison de son fonctionnement multimodal, car il permet de minimiser les fausses détections ou non-détections de personnes par fusion des données d'image fournies par les deux matrices de pixels. Enfin, il fournit à faible coût une information beaucoup plus riche que celle qui est habituellement fournie.

D'autres caractéristiques et avantages de l'invention apparaîtront à la lecture de la description détaillée qui suit et qui est faite en référence aux dessins annexés dans lesquels :
- la figure 1 représente une vue éclatée d'un détecteur de présence selon l'invention ;
- la figure 2 représente une vue simplifiée de dessus du circuit intégré constituant le coeur du capteur ;
- la figure 3 représente une vue en coupe du détecteur, avec les éléments optiques de projection d'image associés à ce circuit ;
- la figure 4 représente une vue de dessus du détecteur ;
- la figure 5 représente une vue en perspective du détecteur ;
- la figure 6 représente une vue de dessus d'une variante de réalisation.

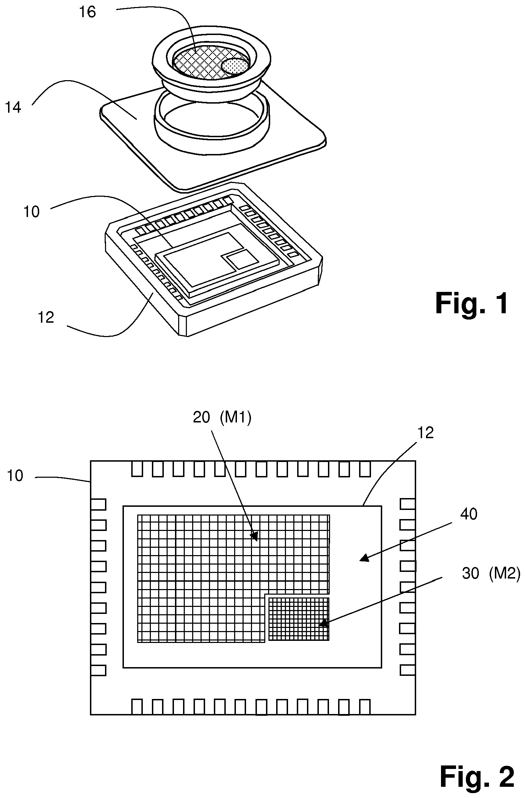

Sur la figure 1, on a représenté les éléments principaux du détecteur compact multimodal selon l'invention. Le coeur du détecteur est constitué par une puce de circuit intégré 10 de technologie CMOS utilisant du silicium encapsulée dans un boîtier céramique ou plastique 12. La puce 10 comprend trois éléments principaux juxtaposés sur la matrice :
- une première matrice de pixels, rendus sensibles au rayonnement infrarouge lointain, notamment dans la bande de longueurs d'onde de 8 à 14 micromètres, par le dépôt d'une couche pyroélectrique ; on notera que le corps humain émet un rayonnement aux alentours de 9 micromètres (rayonnement du corps noir à 30°C),
- une deuxième matrice de pixels sensibles à la lumière visible, et plus généralement aux longueurs d'onde auxquelles le silicium est photosensible, c'est-à-dire entre 300 et 1100 nanomètres, incluant le visible (300 à 800 nanomètres) et le très proche infrarouge (800 à 1100 nanomètres),
- des circuits de lecture et traitement de signal permettant de recueillir les signaux issus de chacune des deux matrices et obtenir ainsi deux images électroniques de la scène capturée par le détecteur, l'une en infrarouge lointain l'autre en lumière visible.

Le boîtier du détecteur est fermé par un capot 14 qui permet d'assurer la protection de la puce tout en laissant passer la lumière et le rayonnement infrarouge lointain venant de l'extérieur vers la surface de la puce. La partie supérieure du capot 14 maintient en place une optique de focalisation multimodale 16. L'optique de focalisation est multimodale en ce sens qu'elle agit à la fois sur la lumière visible et sur le rayonnement infrarouge lointain. Elle comporte à cet effet une partie qui focalise le rayonnement infrarouge lointain sur une matrice de pixels sensibles à ce rayonnement pour y former une image de la scène observée et une partie qui focalise la lumière visible sur une autre matrice de pixels, plus petite que la première et sensible à la lumière visible, pour y former une deuxième image de la scène observée. Bien que ce ne soit pas visible sur la figure 1 pour des raisons de simplification de la représentation, les deux optiques de focalisation sont de préférence dans des plans différents, l'optique en lumière visible étant plus proche de la surface de la puce que l'optique en rayonnement infrarouge lointain.

La figure 2 représente une vue de dessus du boîtier 12 et de la puce 10. On a représenté symboliquement sur la puce une zone 20 qui contient une matrice M1 de pixels rendus sensibles au rayonnement infrarouge lointain, notamment dans la bande de longueurs d'onde de 8 micromètres à 14 micromètres. La matrice comprend de préférence au moins 250 pixels de manière à former une véritable image infra-rouge dans laquelle peuvent être reconnues des formes et notamment des formes caractéristiques d'une présence humaine. Dans un cas simple la matrice M1 possède environ 16 pixels en ligne et 16 pixels en colonne. Dans un autre exemple, permettant une meilleure résolution d'image, il y a 240 pixels en ligne et 240 pixels en colonne. La surface de chaque pixel est de 1000 à 5000 micromètres carrés (environ 30 à 70 micromètres de côté), mais pas au-dessous pour pouvoir avoir à la fois une sensibilité suffisante et une compatibilité avec une optique de focalisation peu coûteuse qui ne permettrait pas une précision optique suffisante pour discriminer des pixels plus petits.

On a représenté également sur la puce une autre zone 30 qui contient une matrice M2 de pixels sensibles à la lumière visible, par exemple une matrice de pixels actifs dans laquelle chaque pixel comporte une photodiode formée dans le silicium de la puce, un transistor d'amplification et des transistors de commande de lecture et de réinitialisation. Cette matrice est sensible à des longueurs d'onde pouvant aller de 300 à 800 nanomètres, voire même jusqu'à presque 1100 nanomètres, le silicium étant photosensible jusqu'à cette longueur d'onde.

La matrice M2 est plus petite en surface que la matrice M1, et de préférence au moins 5 ou 10 fois plus petite. On peut cependant utiliser pour la matrice M2 un nombre de lignes et de colonnes semblable à celui de la matrice M1. En effet, les pixels de la matrice M2 peuvent être beaucoup plus petits que ceux de la matrice M1 sensible à l'infrarouge lointain. Ils font par exemple 10 à 15 micromètres de côté. L'utilisation d'une petite partie de la puce de circuit-intégré pour établir une image en lumière visible ayant la même résolution que l'image en infrarouge lointain ne détériore que très peu la qualité de la matrice infrarouge lointain M1.

Le reste de la puce de circuit intégré (zone 40 sur la figure 2) comprend toute la circuiterie électronique nécessaire au fonctionnement des deux matrices, pour permettre le recueil d'une image en lumière visible et d'une image en rayonnement infrarouge lointain.

Comme on le sait, le silicium est directement sensible à la lumière visible. La matrice M2 sensible à la lumière visible est donc directement exposée à la lumière visible par l'intermédiaire de l'optique de focalisation associée.

Mais le silicium n'est pas sensible au rayonnement infrarouge lointain, surtout dans la bande de longueurs d'onde désirée de 8 à 14 micromètres. Pour assurer la sensibilité des pixels de la matrice M1 à l'infrarouge lointain, la zone 20 de la matrice M1 (mais pas la zone 30 de la matrice M2) est recouverte d'une couche d'un matériau pyroélectrique qui est sensible au rayonnement infrarouge lointain et qui convertit localement en charges électriques ce rayonnement. Les charges électriques engendrées pixel par pixel sont mesurées par les circuits de conversion charge-tension individuels d'un circuit matriciel de lecture formé dans la puce de silicium sous la couche pyroélectrique ; cette mesure de charges fournit l'image en infrarouge lointain désirée. Chaque pixel est constitué par une capacité formée entre une électrode individuelle du pixel et une électrode commune à tous les pixels, les deux électrodes étant séparées par une couche diélectrique qui est formée par le matériau pyroélectrique. La matrice M1 est donc constituée par un réseau de lignes et colonnes d'électrodes de pixels, et un circuit élémentaire de mesure de charges électriques formé dans la puce de silicium, situé au-dessous de chaque électrode de pixel et relié à cette électrode.

Un matériau pyroélectrique adapté est le P(VDF-TrFE), c'est-à-dire un copolymère poly(difluorure de vinylidène -tétrafluoroéthylène) dans lequel le composé pyroélectrique est le poly-difluorure de vinylidène (PVDF), présent dans des proportions de 65 à 80%. Des méthodes de dépôt sont décrites dans la publication de brevet PCT/EP/2008/067289. Le matériau est déposé localement sur la zone 20 de la puce mais pas sur la zone 30, après la formation de toute la circuiterie électronique dans le silicium de la puce de circuit intégré.

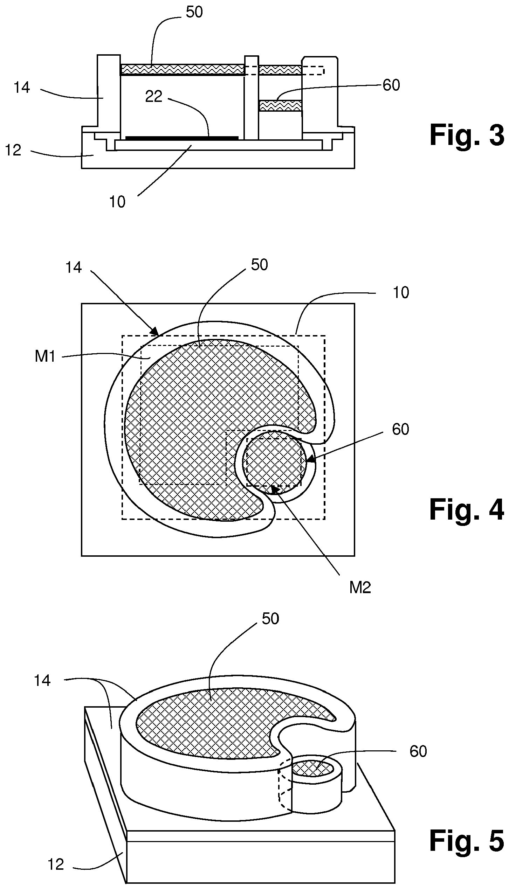

La figure 3 représente une coupe latérale du détecteur, montrant les éléments optiques de focalisation situés au-dessus de la puce de circuit intégré 10. On a désigné par la référence 22 la couche de matériau pyroélectrique, présente au-dessus de la matrice infrarouge mais absente au-dessus de la matrice visible. Les électrodes associées à cette couche pour définir les pixels ne sont pas représentées sur la figure 3.

L'optique de focalisation infrarouge est désignée par la référence 50 et l'optique de focalisation en lumière visible est désignée par la référence 60 ; l'optique infrarouge 50 focalise une image sur une surface (celle de la matrice M1) de plus grande dimension que l'optique visible 60. Elle est située plus haut que l'optique visible au-dessus de la surface de la puce. Les optiques de focalisation sont de préférence des lentilles de Fresnel formées dans un matériau transparent aux longueurs d'onde respectives visibles ou infrarouge lointain. Le matériau peut être le même ou non pour les deux optiques.

Les éléments optiques 50 et 60 peuvent être réalisées dans les matériaux suivants : de préférence en polyéthylène qui permet de minimiser le coût de fabrication tout en étant compatible avec la résolution d'image utilisée (pixels d'au moins 1000 micromètres carrés et d'au plus 5 000 ou 10 000 micromètres carrés) ; les lentilles de focalisation 50 et 60 peuvent éventuellement aussi être en silicium, en verre chalcogénide, ou en germanium. Les lentilles de Fresnel en polyéthylène permettent une ouverture allant jusqu'à F/0,5 où F est la focale de la lentille.

Si l'ouverture des optiques est sensiblement égale à 1, la hauteur de l'optique au-dessus de la surface de la puce est de l'ordre du diamètre de l'optique.

La figure 4 représente une vue de dessus du détecteur, c'est-à-dire qu'on voit principalement les optiques de focalisation 50 (infrarouge lointain) et 60 (lumière visible). Les contours de la puce de circuit intégré 10 et des matrices M1 et M2 de ce circuit sont représentés en traits tiretés.

La figure 5 représente le détecteur en perspective, montrant encore la différence de hauteur des lentilles de focalisation 50 et 60 par rapport à la surface de la puce.

Dans un exemple de réalisation, la puce de circuit intégré fait environ 5x10 millimètres de côté, le diamètre de l'optique infrarouge est d'environ 12,5 millimètres, la distance focale est de 6,5 millimètres, et l'optique 50 est située à 6,5 millimètres au-dessus de la surface de la puce. Le détecteur est donc très compact. Dans cet exemple, la zone de matrice visible M2 est de l'ordre de 1,5 millimètres de côté ; l'optique de focalisation 60 de la lumière visible a un diamètre de 4 millimètres, et sa distance focale est de 3 millimètres ; elle est située à 3 millimètres au-dessus de la surface de la puce.

Dans un autre exemple, la puce de circuit intégré mesure environ 6x8 millimètres, l'optique infrarouge a un diamètre de 8 millimètres environ, avec une focale de 4 millimètres et elle est située à 4 millimètre au-dessus de la surface de la puce. La lentille visible a encore un diamètre de 4 millimètres et une distance focale de 3 millimètres et elle est située à 3 millimètres au-dessus de la puce.

Pour minimiser les coûts, on prévoit en outre que le capteur ne possède pas de système de hachage optique, c'est-à-dire de système d'obturation périodique de la lumière, permettant une mesure différentielle entre les charges mesurées en présence de lumière (première demi-période de hachage) et en l'absence de lumière (deuxième demi-période de hachage). L'inconvénient est la difficulté d'observation d'une image en mouvement très lent, mais c'est rarement un inconvénient pour la détection de personnes ou pour la détection d'interactions Homme-Machine, dans laquelle il y a en principe suffisamment de mouvement pour qu'il n'y ait pas de difficulté à reconstituer une image même sans hachage optique. Le traitement d'images par un processeur (dans la puce ou en dehors de la puce) permet de pallier l'absence de hachage parce qu'il permet de fournir par soustraction d'images successives des informations mettant en évidence des mouvements.

Dans une réalisation particulière, on prévoit que le détecteur est apte en outre à recueillir une image en trois dimensions, c'est-à-dire qu'il peut affecter une information de profondeur aux différents points de l'image. On obtient ce résultat en associant à la matrice infrarouge non pas une matrice de pixels sensibles à la lumière visible mais deux matrices sensibles à la lumière visible, qui sont écartées l'une de l'autre. Une optique de focalisation respective est associée à chacune de ces deux matrices visibles et focalise la même scène d'image sur les deux matrices. Une corrélation entre les images des deux matrices permet de déterminer pour chaque pixel d'une première image quel est le pixel de la deuxième image qui a vu le même point de la scène observée. La distance entre les deux pixels, c'est-à-dire la différence de position relative entre les deux pixels à l'intérieur de leur matrice respective, représente directement l'information de profondeur, c'est-à-dire une distance entre le détecteur et le point de la scène vu par ces deux pixels ; dans le cas général (même axe optique des lentilles) une distance nulle entre les deux pixels correspond à une profondeur infinie ; la profondeur diminue au fur et à mesure que la distance entre les deux pixels augmente.

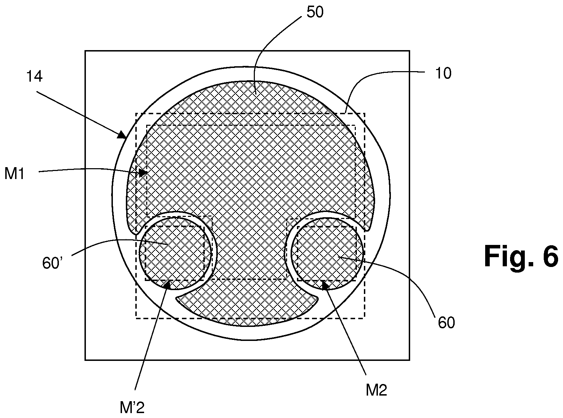

La figure 6 représente en vue de dessus le détecteur dans cette solution, avec les deux matrices M2 et M2' de pixels photosensibles en lumière visible, placées de part et d'autre de la matrice de pixels photosensibles en infrarouge lointain et au-dessous de lentilles de focalisation respectives 60 et 60'.

On notera qu'on pourrait aussi obtenir une information en trois dimensions en utilisant d'autres moyens connus, par exemple ce qu'on appelle une mesure du temps de vol ; le temps de vol est le temps mis par une impulsion lumineuse pour aller jusqu'à un point de la scène observée et en revenir. Connaissant la vitesse de la lumière, on déduit la distance du temps. Cette mesure nécessite cependant des moyens plus sophistiqués et nécessite en particulier qu'on intègre au détecteur une source d'impulsions lumineuses (par exemple une diode laser) et qu'on synchronise le fonctionnement des circuits de lecture des matrices avec l'émission des impulsions lumineuses.

Les données d'image fournies par les matrices de pixels sensibles à la lumière visible et au rayonnement infrarouge lointain seront exploitées séparément ou en combinaison. Des algorithmes de fusion de données pourront être mis en place soit dans la puce soit à l'extérieur pour associer les images visibles et infrarouge lointain et augmenter la fiabilité de la détection de personne en éliminant les détections qui ne seraient pas confirmées par les deux modes de prise d'image.

## Revendications

1. Détecteur de présence de personne comportant sur une même puce de silicium (10) réalisée en technologie CMOS une première matrice (M1) de pixels, rendus sensibles au rayonnement infrarouge lointain par le dépôt d'une couche pyroélectrique, convertissant en charges électriques le rayonnement infrarouge lointain reçu, juxtaposée avec au moins une deuxième matrice (M2) de pixels sensibles à la lumière visible, convertissant en charges électriques la lumière visible reçue, et un circuit de lecture des charges engendrées dans chacune des matrices par la lumière visible ou le rayonnement infrarouge lointain, le détecteur comprenant encore, au-dessus de la puce de silicium, un élément optique (50) de focalisation du rayonnement infrarouge lointain sur la première matrice, et un élément optique (60) de focalisation de la lumière visible sur la deuxième matrice.

2. Détecteur selon la revendication 1, **caractérisé en ce que** la deuxième matrice occupe une faible partie, inférieure à 25%, de la surface de la première matrice.

3. Détecteur selon l'une des revendications 1 et 2, **caractérisé en ce que** la taille des pixels de la deuxième matrice est au moins cinq fois inférieure à la taille en surface des pixels de la première matrice.

4. Détecteur selon l'une des revendications 1 à 3, **caractérisé en ce que** la deuxième matrice est placée contre un bord ou un coin de la première matrice.

5. Détecteur selon l'une des revendications 1 à 4, **caractérisé en ce que** la première matrice comprend une couche superficielle de matériau pyroélectrique organique, notamment un copolymère de poly(fluorure de vinylidène-tétrafluroéthylène), et des électrodes de part et d'autre de cette couche pour recueillir les charges engendrées dans la couche par le rayonnement infrarouge.

6. Détecteur selon l'une des revendications 1 à 5, **caractérisé en ce que** la deuxième matrice est divisée en deux parties écartées latéralement l'une de l'autre, permettant une détection d'image visible en trois dimensions, un élément optique de focalisation respectif étant disposé au-dessus de chaque partie.

7. Détecteur selon l'une des revendications 1 à 6, **caractérisé en ce qu'**au moins un des éléments optiques de focalisation est une lentille de Fresnel.

8. Détecteur selon l'une des revendications 1 à 7, **caractérisé en ce qu'**au moins un élément optique de focalisation est réalisé en polyéthylène ou en silicium, ou en verre chalcogénide, en fluorure de calcium, de baryum ou de magnésium, ou en germanium.

## Patentansprüche

1. Detektor zum Erkennen der Anwesenheit einer Person, der auf einem selben in CMOS-Technologie ausgeführten Siliziumchip (10) eine erste Matrix (M1) von durch Aufbringen einer pyroelektrischen Schicht zur Ferninfrarotstrahlung empfindlich gemachten Pixeln aufweist, die die empfangene Ferninfrarotstrahlung in elektrische Ladungen umwandelt, und die an mindestens einer zweiten Matrix (M2) von zum sichtbaren Licht empfindlichen Pixeln aneinandergelegt wird, die das empfangene sichtbare Licht in elektrische Ladungen umwandelt, und der eine Leseschaltung zum Lesen der durch das sichtbare Licht oder die Ferninfrarotstrahlung in jeder der Matrizen erzeugten Ladungen aufweist, wobei der Detektor dazu oberhalb des Siliziumchips ein optisches Element (50) zum Fokussieren der Ferninfrarotstrahlung auf die erste Matrix und ein optisches Element (60) zum Fokussieren des sichtbaren Lichts auf die zweite Matrix umfasst.

2. Detektor nach Anspruch 1, **dadurch gekennzeichnet, dass** die zweite Matrix einen kleinen, unter 25% liegenden Teil der Fläche der ersten Matrix einnimmt.

3. Detektor nach einem der Ansprüche 1 und 2, **dadurch gekennzeichnet, dass** die Größe der Pixel der zweiten Matrix mindestens fünfmal kleiner ist als die Oberflächengröße der Pixel der ersten Matrix.

4. Detektor nach einem der Ansprüche 1 bis 3, **dadurch gekennzeichnet, dass** die zweite Matrix an einer Kante oder an einer Ecke der ersten Matrix angeordnet ist.

5. Detektor nach einem der Ansprüche 1 bis 4, **dadurch gekennzeichnet, dass** die erste Matrix eine Oberflächenschicht aus einem pyroelektrischen organischen Material, insbesondere ein Polyvinylidenfluorid-Tetrafluroethylen-Copolymer, und Elektroden beiderseits dieser Schicht umfasst, um die in der Schicht durch die Infrarotstrahlung erzeugten Ladungen zu sammeln.

6. Detektor nach einem der Ansprüche 1 bis 5, **dadurch gekennzeichnet, dass** die zweite Matrix in zwei seitlich voneinander beabstandeten Abschnitten so aufgeteilt ist, dass eine Erkennung eines dreidimensionalen sichtbaren Bildes ermöglicht wird, wobei ein jeweiliges fokussierendes optisches Element oberhalb jedem Abschnitt angeordnet ist.

7. Detektor nach einem der Ansprüche 1 bis 6, **dadurch gekennzeichnet, dass** mindestens eines der fokussierende optischen Elemente eine Fresnellinse ist.

8. Detektor nach einem der Ansprüche 1 bis 7, **dadurch gekennzeichnet, dass** mindestens ein fokussierendes optisches Element aus Polyethylen oder aus Silizium, oder aus Chalkogenidglas, aus Calcium-, Barium- oder Magnesiumfluorid, oder aus Germanium ausgeführt wird.

## Claims

1. A human presence detector including on a same silicon chip (10) made in CMOS technology a first array (M1) of pixels, made sensitive to far infrared radiation by depositing a pyroelectric layer, converting the received far infrared radiation into electric charges, juxtaposed with at least one second array (M2) of pixels responsive to visible light, converting the received visible light into electric charges, and a circuit for reading the charges generated in each of the arrays by the visible light or far infrared radiation, the detector further comprising, above the silicon chip, an optical element (50) for focusing the far infrared rays on the first array, and an optical element (60) for focusing the visible light on the second array.

2. The detector according to claim 1, wherein the second array occupies a small portion, less than 25%, of the surface area of the first array.

3. The detector according to one of claims 1 and 2, wherein the pixel size of the second array is at least five times smaller, in surface area, than the pixels of the first array.

4. The detector according to one of claims 1 to 3, wherein the second array is adjacent an edge or a corner of the first array.

5. The detector according to one of claims 1 to 4, wherein the first array comprises a surface layer of organic pyroelectric material, in particular a poly(vinylidenefluoride-co-trifluoroethylene) copolymer, and electrodes on both of side of this layer to collect charges generated in the layer by infrared radiation.

6. The detector according to one of claims 1 to 5, wherein the second array is divided into two laterally spaced parts, allowing visible image sensing in three dimensions, a respective optical focusing element being placed above each part.

7. The detector according to one of claims 1 to 6, wherein at least one the optical focusing elements is a Fresnel lens.

8. The detector according to one of claims 1 to 7, wherein at least one of the optical focusing elements is made of polyethylene or silicon, or chalcogenide glass, calcium, barium or magnesium fluoride, or germanium.
